# EUROPÄISCHE PATENTSCHRIFT

(11) **EP 0 931 178 B1**
(45) Veröffentlichungstag und Bekanntmachung des Hinweises auf die Patenterteilung: **23.05.2001**
(21) Anmeldenummer: 96946230.8
(22) Anmeldetag: 30.12.1996
(51) Int. Cl.: C23C 16/36, C23C 30/00, C23C 28/04, B23B 27/14, C23C 14/06

(54) **VERBUNDKÖRPER, VERFAHREN ZU SEINER HERSTELLUNG UND VERWENDUNG DES VERBUNDKÖRPERS**
COMPOSITE BODY, PRODUCTION PROCESS AND USE
CORPS COMPOSITE, MODE DE FABRICATION ET UTILISATION

(30) Priorität: 09.10.1996 DE 19641468; 09.10.1996 DE 29617507 U
(43) Veröffentlichungstag der Anmeldung: 28.07.1999
(73) Patentinhaber: Widia GmbH, 45145 Essen (DE)
(72) Erfinder: VAN DEN BERG, Hendrikus, NL-5925 BT Venlo-Blerick (NL); KÖNIG, Udo, D-45149 Essen (DE); DREYER, Klaus, D-45138 Essen (DE); SOTTKE, Volkmar, D-45468 Mülheim (DE); WESTPHAL, Hartmut, D-36466 Dermbach (DE)
(74) Vertreter: Vomberg, Friedhelm, Dipl.-Phys.
(86) Internationale Anmeldenummer: DE9602519
(87) Internationale Veröffentlichungsnummer: WO9815671

(56) Entgegenhaltungen:
- EP-A- 0 629 713
- EP-A- 0 732 423
- DE-A- 2 505 007
- PATENT ABSTRACTS OF JAPAN vol. 010, no. 166 (C-353), 13.Juni 1986 & JP 61 019777 A (SUMITOMO DENKI KOGYO KK), 28.Januar 1986,
- DATABASE WPI Section Ch, Week 8922 Derwent Publications Ltd., London, GB; Class L02, AN 89-161999 XP002033137 & JP 01 104 773 A (SUMITOMO ELECTRIC IND CO) , 21.April 1989
- PATENT ABSTRACTS OF JAPAN vol. 009, no. 317 (C-319), 12.Dezember 1985 & JP 60 149775 A (MITSUBISHI KINZOKU KK), 7.August 1985,

## Beschreibung

Die Erfindung betrifft einen Verbundkörper, der aus einem Substratkörper mit einer ein- oder mehrlagigen Beschichtung aus Carbiden, Nitriden, Carbonitriden des Ti, Zr, Hf, V, Nb und/oder Ta und/oder aus Al₂O₃ oder ZrO₂ besteht.

Die Erfindung betrifft ferner Verfahren zur Herstellung einer Beschichtung aus einem Carbonitrid des Zr, Hf, V, Nb, Ta oder Cr nach den Oberbegriffen der Ansprüche 1 und 13.

Ferner werden Verwendungen des Verbundkörpers angegeben.

Die ersten, nach dem Stand der Technik bekanntgewordenen Beschichtungen bestanden aus Titancarbid mit einer Dicke bis zu 8 µm, womit eine verbesserte Verschleißschutzwirkung gegen den Freiflächenverschleiß erzielt werden konnte. Weiterhin gehören Doppel- oder Mehrfachbeschichtungen aus Titancarbid und Titannitrid, insbesondere mit Titannitrid als Außenlage zum Stand der Technik, womit eine verminderte Kolkung bei zum Zerspanen eingesetzten Schneideinsätzen erreicht werden konnte. Zur weiteren Verbesserung solcher Schneideinsätze sind auch Mehrlagenbeschichtungen mit der Schichtfolge TiC, Ti(C,N)-TiN vorgeschlagen worden. Nachdem man erkannt hatte, daß die naturbedingte Sprödigkeit von Keramiken, wie Al₂O₃ minimiert werden kann, wenn Al₂O₃ in dünnlagiger Form aufgetragen wird, sind auch aus TiC, Ti(C,N) und einer Außenlage aus Al₂O₃ bestehende Mehrfachbeschichtungen verwendet worden. Obwohl in der Patentliteratur wie beispielsweise im Rahmen der ein spezielles Beschichtungsverfahren betreffenden EP 0 229 282 B1 generell von Carbiden, Nitriden und/oder Carbonitriden der Elemente Titan, Zirkonium, Hafnium, Vanadium, Niob und/oder Tantal gesprochen wird, beschränkten sich die jeweils beschriebenen Ausführungsbeispiele auf Titanverbindungen als Beschichtungsmaterial, zum Teil in Kombination mit Aluminiumoxid. Entsprechendes gilt hinsichtlich der ZrO₂ in Verbindung oder als Ersatz für oxidhaltige Beschichtungen. Erst in der DE 36 20 901 A1 oder der inhaltlich gleichlautenden EP 0 250 865 A1 ist ein Schneidwerkzeug beschrieben, dessen Schneide mit Titancarbid, Titancarbonitrid und/oder Titannitrid beschichtet ist und dessen äußere Deckschicht aus einer dünnen Zirkonnitridschicht bestehen soll. Das Zirkonnitrid, das schlechtere Verschleißeigenschaften als die vorgenannten Titan-Verbindungen hat, soll eine Oxidation der unter dieser Schicht liegenden Basisbeschichtungen durch den Luftsauerstoff verhindern, womit die guten Verschleißeigenschaften der Titancarbid-, Titancarbonitrid- und/oder Titannitridschichten voll erhalten bleiben. In der Praxis ist von Zirkoniumverbindungen als Beschichtungsmaterial ansonsten kein Gebrauch gemacht worden.

Darüber hinaus wird noch in der US-A-3 854 991 (oder
CH-A-585 273) ein beschichtetes Sinterhartmetallprodukt beschrieben, bei dem der Überzug aus HfCN und/oder ZrCN besteht und eine Röntgenbeugungs-Gitterkonstante haben soll, welche im Falle von HfCN und einer Mischung aus HfCN und ZrCN zwischen 4,570 und 4,630 Angström liegt und im Fall von ZrCN zwischen 4,6 und 4,62 Angström. Im Falle von ZrCN ist das C/N-Verhältnis deutlich kleiner als 1. Zur Herstellung dieses Hafnium- oder Zirkoniumcarbonitrids wird ein Hafnium- und/oder Zirkoniumhalogenid zusammen mit Wasserstoff, Stickstoff und einem Kohlenwasserstoff bei einer Temperatur von 1000 bis 1300°C über das Substrat geleitet.

Die JP 61-19777 beschreibt einen Verbundkörper und einen Hartmetall-Substratkörper mit einer mehrlagigen Beschichtung, die eine aus Al₂O₃ und/oder ZrO₂ bestehende Zwischenschicht, eine am Substratkörper anliegende Innenschicht aus einem Carbid und/oder Carbonitrid des Titan, Zirkons oder Hafniums und eine Außenschicht aus einem Nitrid und/oder Carbonitrid des Hafniums oder Zirkons hat.

Das Dokument DATABASE WPI Section Ch, Week 8922 Derwent Publications Ltd., London, GB; Class L02, AN 89-161999 XP002033137 & JP 01 104 773 A offenbart ein Verfahren zur Herstellung einer Beschichtung, u.a. aus Carbonitriden der Gruppe IVa-Übergangsmetalle mittels CVD, wobei die Gasphase ein Salz der obengenannten Metalle, Methan, Stickstoff oder organische Stickstoffdonatoren (z.B. CH₃CN) und Wasserstoff als Trägergas enthält, und wobei die Hartstoffschichten bei einer Reaktionstemperatur zwischen 700°C und 900°C und einem Druck von 0,1 bis 20 Torr (13 bis 2666 Pa) auf einem Grundkörper aufgetragen werden.

Es ist Aufgabe der vorliegenden Erfindung, einen aus einem mit einer mehrlagigen Beschichtung versehenen Substratkörper bestehenden Verbundkörper zu schaffen, dessen Verschleißeigenschaften beim Zerspanen oder unter sonstiger abrasiver Belastung im Hinblick auf eine verlängerte Standzeit verbessert sind. Diese Aufgabe wird durch den Verbundkörper nach Anspruch 1 gelöst, der dadurch gekennzeichnet ist, daß entweder auf einer mindestens 2 µm dicken Al₂O₃- oder ZrO₂-Schicht eine Schicht (16) aus einem Carbonitrid des Zr, Hf, V, Nb, Ta oder Cr abgeschieden worden ist oder auf einer mindestens 2 µm dicken Al₂O₃- oder ZrO₂-Schicht eine dünne Zwischenlage und hierauf eine Schicht (16) aus einem Carbonitrid des Zr, Hf, V, Nb, Ta oder Cr abgeschieden worden ist, wobei die Zwischenlage entweder aus ZrC oder ZrN mit einer maximalen Dicke von 0,5 µm besteht oder aus TiN mit einer maximalen Dicke von 0,1 µm besteht. Die genannte Carbonitridschicht hat vorzugsweise eine Dicke von mindestens 2 µm bis maximal 6 µm und/oder die Al₂O₃- oder ZrO₂-Schicht eine Dicke von 2 µm, vorzugsweise 3 µm oder mehr. Die betreffende Dicke soll bei Verbundkörpern, die als Schneideinsätze ausgebildet sind, an den Schneidecken vorliegen. Es ist sowohl möglich, daß die äußere Schicht aus dem genannten Carbonitrid, insbesondere ZrCN oder HfCN besteht, als auch daß auf dieser Carbonitridschicht eine oder mehrere äußere Schichten aufgetragen worden sind, wobei die Dicke oder die Gesamtdicke dieser einen oder mehreren äußeren Schichten 2 µm, vorzugsweise 1 µm nicht übersteigen soll. Mit anderen Worten, im Rahmen der vorliegenden Erfindung erhält man gleich gute Lösungen, wenn die genannte Carbonitridschicht nur von extrem dünnen weiteren Schichten überlagert ist.

Vorzugsweise soll die Gesamtdicke der beiden Schichten aus Al₂O₃ und/oder ZrO₂ einerseits und dem genannten Carbonitrid andererseits mindestens 5 µm betragen, vorzugsweise jedoch maximal 10 µm.

Unterhalb der beiden Schichten aus Al₂O₃ und/oder ZrO₂ einerseits und einem Carbonitrid des Zr, Hf, V, Nb, Ta oder Cr können eine oder mehrere Schichten aus Nitriden, Carbonitriden oder Carbiden der Elemente der IVa- oder Va-Gruppe des Periodensystemes angeordnet sein, vorzugsweise Carbide, Nitride und/oder Carbonitride des Titans, Zirkoniums und/oder Hafniums. Die betreffende Schichtfolge der Carbide, Nitride oder Carbonitride kann beliebig gewählt werden, sollte jedoch weiterhin vorzugsweise von innen nach außen lauten: TiN, TiCN, Al₂O₃ und ZrCN. Bevorzugt werden bei solchen Verbundkörpern, die als Schneideinsatz zum Drehen verwendet werden, folgende Schichtdicken verwendet: TiN: 0,5 bis 2 µm; TiCN: 9 bis 13 µm; Al₂O₃: 2 bis 4,5 µm und ZrCN: 2 bis 4 µm. Bei entsprechenden Schneideinsätzen zum Fräsen werden bevorzugt die Schichtdicken wie folgt gewählt: TiN: 0,5 bis 2 µm; TiCN: 9 bis 13 µm; Al₂O₃ und ZrCN: 4 bis 6 µm, wobei eine der Schichten Al₂O₃ und ZrCN mindestens 1 µm dick ist.

Der Substratkörper kann nach einer weiteren Ausgestaltung der Erfindung aus Hartmetall, einem Stahl, einem Cermet oder einer Keramik, insbesondere auf der Basis von Si₃N₄ bestehen. Bevorzugte Hartmetallsubstratkörper besitzen 5,5 bis 8,5 Massen-% Co, vorzugsweise 5,5 bis 6,5 Massen-% Co als Binder, Rest WC. Alternativ kann der Substratkörper 1 bis 3 Massen-% TiC, 2 bis 5 Massen-% TaC, 1 bis 3 Massen-% NbC, 5,5 bis 8,5 Massen-% Co, Rest WC aufweisen.

Zur Herstellung der Carbonitridschicht aus Zr, Hf, V, Nb, Ta oder Cr wird nach einer ersten Alternative auf ein plasmaaktiviertes CVD-Verfahren zurückgegriffen, bei dem die reaktive Gasatmosphäre bei der eingestellten Reaktionstemperatur neben Wasserstoff, Argon, einem Chlorid der genannten Metalle auch ionisierte und/oder nicht ionisierte Kohlenstoff-Stickstoff-Donatoren mit Dreifachbindungen enthält, wobei der Abstand der Bindung zwischen dem Kohlenstoff und dem Stickstoff bei Raumtemperatur zwischen 0,114 und 0,118 nm liegt. Die ionisierten und die nicht ionisierten C-N-Donatoren werden durch Ionisierung und thermische Dissoziation von Gasen mit Cyanidgruppen (CN-Dreifachbindungen) mittels einer Plasmaaktivierung bei Temperaturen zwischen 400°C und 700°C und einem Druck von 100 bis 1000 Pa erzeugt. Geeignete Stoffe, die bei der Reaktionstemperatur Cyanradikale(-CN) freisetzen können, sind organische Verbindungen, wie Cyanwasserstoff, Cyanamid, Cyanogen, Cyanoacethylen und Acetonitril. Bei der Abscheidung kann zur Plasmaaktivierung der Substratkörper als Kathode geschaltet sein, an der eine gepulste Gleichspannung anliegt. Eine derartige Verfahrensführung wird beispielsweise in der DE 38 41 731 C1 beschrieben.

Alternativ ist es auch möglich, die genannten Hartstoffschichten aus Carbonitrid mittels CVD aufzutragen, wobei die Gasphase bei einer Reaktionstemperatur zwischen 700°C und 1100°C und vorzugsweise bei Drücken zwischen 5 kPa und 100 kPa, neben H₂ und/oder Ar sowie Chloriden der obengenannten Metalle auch Kohlenstoff- und Stickstoff-Donatoren enthält, die eine C-N-Molekülgruppe aufweisen. Diese ist vorzugsweise eine Cyanidgruppe mit einer Dreifachbindung zwischen dem Kohlenstoff und dem Stickstoff, deren Abstand bei Raumtemperatur zwischen 0,114 und 0,118 nm beträgt. Solche Verbindungen sind Cyanwasserstoff, Cyanamid, Cyanogen, Cyanoacethylen oder Acetonitril. Alternativ oder zum Teil können auch solche gasförmigen Verbindungen verwendet werden, die CN-Molekülgruppen mit einer einfachen Bindung zwischen dem Kohlenstoff und dem Stickstoff aufweisen. Moleküle mit einfachen C-N-Bindungen besitzen Methylamin und Ethylendiamin. Im Rahmen der vorliegenden Erfindung kann auf jeweilige Stoffe zurückgegriffen werden, die Cyanid-Gruppen enthalten; Verbindungen dieser Art sind im Prinzip nach dem Stand der Technik bekannt und werden beispielsweise in der DE 25 05 009 A1 beschrieben. Es können auch andere gasförmige Medien in das Reaktionsgefäß eingeschleust werden, die in der Lage sind, betreffende Cyangruppen bei der Reaktionstemperatur zu bilden.

Bevorzugte Verwendungen des erfindungsgemäßen Verbundkörpers liegen im Einsatz als abrasiv beanspruchtem Verschleißteil oder im Zerspanungseinsatz, hier insbesondere zum Drehen oder Fräsen.

In einem konkreten Ausführungsbeispiel ist ein HartmetallSubstratkörper mit 6 Massen-% Co, Rest WC mit der von innen nach außen folgenden Schichtreihe in der angegebenen Dicke beschichtet worden: 1 µm TiN, 10 µm TiCN, 4 µm Al₂O₃ und 3 µm ZrCN. Die äußere Zirkonnitridschicht erwies sich als vollständig dicht, rißfrei und besaß eine positive Druckeigenspannung. Das C/N-Verhältnis lag etwa bei 1.

Zerspanungseinsätze dieses Schneideinsatzes beim Fräsen, Bohren oder Drehen führten zu Standzeiten, die je nach Zerspanungsbedingungen 1,2 bis 4mal länger waren als die Standzeiten, die mit mehrlagig beschichteten Verbundkörpern erreicht werden konnten, die nach dem Stand der Technik bekannt sind und beispielsweise die Schichtfolge TiN, Al₂O₃ oder ZrN als äußerste Schicht aufwiesen.

Die guten Standzeiteigenschaften konnten selbst dann beibehalten werden, wenn anstelle der äußeren ZrCN-Deckschicht noch andere dünne Schichten, z.B. aus TiN aufgetragen waren. Ebenso kam es nicht darauf an, wie viele Schichten unterhalb der Schichtkombination Al₂O₃/ZrCN angeordnet waren und welche Dicke diese Schichten unter der Al₂O₃/ZrCN-Schichtfolge besitzen. So konnten mit besseren Standzeiten Beschichtungen eingesetzt werden, deren Gesamtschichtdicke bis zu 26 µm betrug. Entsprechendes gilt auch für solche Fälle, bei denen das Zirkonium in der Carbonitrid-Schicht ganz oder teilweise durch Hafnium, Vanadium, Niob, Tantal oder Chrom ersetzt war.

Das gute Standzeitverhalten konnte selbst dann realisiert werden, wenn zwischen der Schichtfolge Al₂O₃/ZrCN noch eine dünne Zwischenlage aus TiN von maximal 0,1 µm aus TiN oder eine dünne Zwischenlage von maximal 0,5 µm aus ZrC oder ZrN vorhanden war.

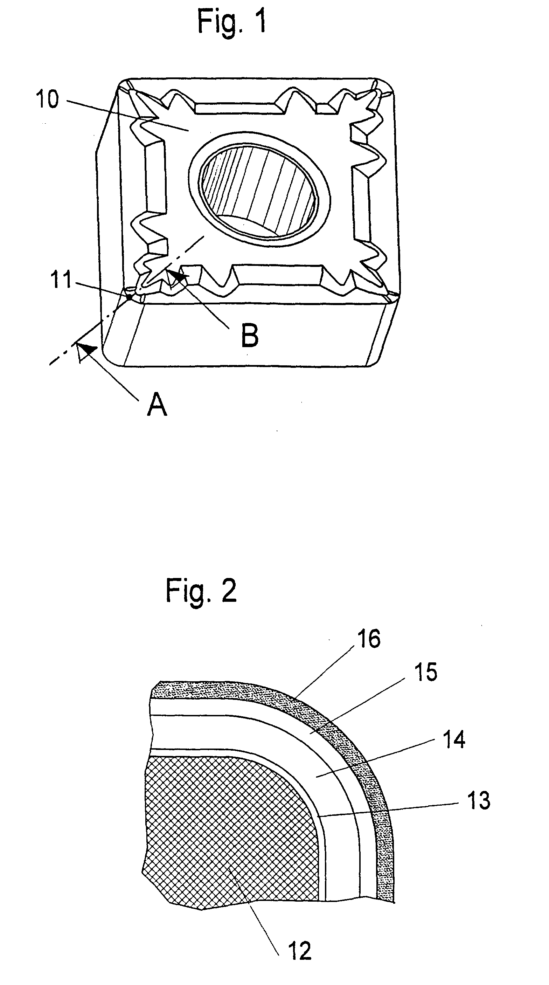

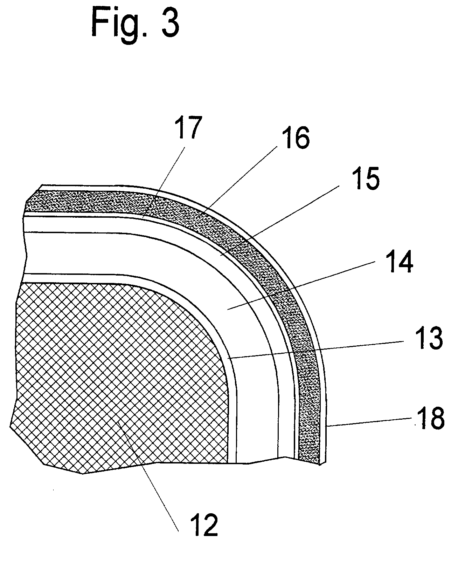

Fig. 1 zeigt einen Schneideinsatz 10, dessen Schneidecke 11 im Schnitt entlang der Linie A - B in Fig. 2 bzw. in einer Alternativausführung in Fig. 3 schematisch abgebildet ist.

Wie Fig. 2 zu entnehmen ist, ist auf den Substratkörper 12, der aus einem WC-Hartmetall mit 6 % Co als Binder besteht, eine erste, 1 µm dicke Lage 13 aus TiN, eine zweite, 10 µm dicke Lage 14 aus TiCN, eine weitere 4 µm dicke Lage 15 aus Al₂O₃ und eine äußere, 3 µm dicke Deckschicht 16 aus ZrCN aufgetragen.

Die Ausführungsform nach Fig. 3 unterscheidet sich von der vorbeschriebenen Ausführungsform nach Fig. 2 dadurch, daß zwischen der Schicht 16 aus ZrCN und der Lage 15 aus Al₂O₃ eine 0,1 µm dicke Schicht 17 aus TiN angeordnet ist. Zusätzlich ist eine äußere 0,1 µm dicke TiN-Schicht 18 als äußere Deckschicht vorgesehen.

Wie aus den nachfolgenden Zerspanungsergebnissen ersichtlich, haben (unabhängig vom Wendeschneidplattentyp) die erfindungsgemäß beschichteten Wendeschneidplatten gegenüber den nach dem Stand der Technik bekannten Wendeschneidplatten deutlich längere Standzeiten.

### 1. Beispiel

Werkstück: Kugellagerring 152 Ø x 36
Werkstückstoff: Stahl 100Cr6
Schnittgeschwindigkeit: 280 m/min
Vorschub: 0,8 mm/Umdrehung
Schnittiefe: 1,0 mm

| Wendeschneidplatte nach dem Stand der Technik | | gemäß Erfindung |
|---|---|---|
| Plattenform | SNMG120416 | SNMG120416 |
| Beschichtung | Ti(C,N)-Al₂O₃-TiN | TiN-Ti(C,N)-Al₂O₃-Zr(C,N) |
| Schichtdicke gesamt (µm) | 15 | 15 |
| Werkstücke/Schneidecke | 125 | 150 |

### 2. Beispiel

Werkstück: Achszapfen 40 Ø x 100
Werkstückstoff: Stahl C55
Schnittgeschwindigkeit: 200 m/min
Vorschub: 0,7 mm/Umdrehung
Schnittiefe: 2,5 mm - 3,0 mm

| Wendeschneidplatte nach dem Stand der Technik | | gemäß Erfindung |
|---|---|---|
| Plattenform | WNMG050414 | WNMG050414 |
| Beschichtung | TiC-Al₂O₃ | TiN-Ti (C,N) -Al₂O₃-Zr (C,N) |
| Schichtdicke gesamt (µm) | 15 | 15 |
| Werkstücke/Schneidecke | 195 | 235 |

### 3. Beispiel

Werkstück: Freilaufring
Werkstückstoff: Stahl Ck45
Schnittgeschwindigkeit: 220 m/min
Vorschub: 0,25 mm/Umdrehung
Schnittiefe: 2 mm

| Wendeschneidplatte nach dem Stand der Technik | | gemäß Erfindung |
|---|---|---|
| Plattenform | WNMG050408 | WNMG050408 |
| Beschichtung | TiC-Al₂O₃ | TiN-Ti (C, N) -Al₂O₃-Zr (C, N) |
| Schichtdicke gesamt (µm) | 15 | 14 |
| Werkstücke/Schneidecke | 50 | 143 |

### 4. Beispiel

Werkstück: Antriebswelle 50 Ø x 310
Werkstückstoff: Stahl 16MnCr5
Schnittgeschwindigkeit: 260 m/min
Vorschub: 0,4 mm/Umdrehung
Schnittiefe: 2 mm - 3 mm

| Wendeschneidplatte nach dem Stand der Technik | | gemäß Erfindung |
|---|---|---|
| Plattenform | DNMG150612 | DNMG150612 |
| Beschichtung | TiC-Al₂O₃-TiN | TiN-Ti(C,N)-Al₂O₃-Zr(C,N) |
| Schichtdicke gesamt (µm) | 14 | 14 |
| Werkstücke/Schneidecke | 130 | 170 |

## Patentansprüche

1. Verbundkörper, bestehend aus einem Substratkörper (12), mit einer mehrlagigen Beschichtung (13 bis 16) aus Carbiden, Nitriden und/oder Carbonitriden des Ti, Zr, Hf, V, Nb und/oder Ta einerseits und aus Al₂O₃ oder ZrO₂ andererseits,
**dadurch gekennzeichnet,**
daß entweder auf einer mindestens 2 µm dicken Al₂O₃- oder ZrO₂-Schicht eine Schicht (16) aus einem Carbonitrid des Zr, Hf, V, Nb, Ta oder Cr abgeschieden worden ist oder auf einer mindestens 2 µm dicken Al₂O₃- oder ZrO₂-Schicht eine dünne Zwischenlage und hierauf eine Schicht (16) aus einem Carbonitrid des Zr, Hf, V, Nb, Ta oder Cr abgeschieden worden ist, wobei die Zwischenlage entweder aus ZrC oder ZrN mit einer maximalen Dicke von 0,5 µm besteht oder aus TiN mit einer maximalen Dicke von 0,1 µm besteht.

2. Verbundkörper nach Anspruch 1 dadurch gekennzeichnet, daß die Schicht (16) aus einem Carbonitrid des Zr, Hf, V, Nb, Ta oder Cr eine Dicke von mindestens 2 µm bis maximal 6 µm und/oder die Al₂O₃- oder ZrO₂-Schicht eine Dicke von mindestens 3 µm oder mehr aufweist und/oder daß auf der Schicht (16) aus einem Carbonitrid des Zr, Hf, V, Nb, Ta oder Cr eine oder mehrere äußere Schichten aufgetragen worden sind, wobei die Dicke oder die Gesamtdicke dieser einen oder mehreren Schicht(en) 2 µm, vorzugsweise 1 µm nicht übersteigt.

3. Verbundkörper nach einem der Ansprüche 1 oder 2, dadurch gekennzeichnet, daß die Gesamtdicke der beiden Schichten (15, 16) aus Al₂O₃ und/oder ZrO₂ einerseits und einem Carbonitrid des Zr, Hf, V, Nb, Ta oder Cr andererseits mindestens 5 µm und vorzugsweise maximal 10 µm beträgt und/oder daß unterhalb der beiden Schichten (15, 16) aus Al₂O₃ und/oder ZrO₂ einerseits und einem Carbonitrid des Zr, Hf, V, Nb, Ta oder Cr andererseits eine oder mehrere Schichten (13 bis 15) aus Carbiden, Nitriden, Carbonitriden der Elemente der IVa- oder Va-Gruppe des Periodensystemes angeordnet sind, vorzugsweise Carbide, Nitride und/oder Carbonitride des Titans, Zirkoniums und/oder Hafniums.

4. Verbundkörper nach einem der Ansprüche 1 bis 3, gekennzeichnet durch eine auf dem Substratkörper (12) von innen nach außen aufgebrachte Schichtfolge (13 bis 16) aus TiN, TiCN, Al₂O₃ und ZrCN, vorzugsweise durch folgende Schichtdicken: TiN: 0,5 bis 2 µm; TiCN: 9 bis 13 µm; Al₂O₃: 2 bis 4,5 µm und ZrCN: 2 bis 4 µm oder durch folgende Schichtdicken: TiN: 0,5 bis 2 µm; TiCN: 9 bis 13 µm; Al₂O₃ und ZrCN: 4 bis 6 µm, wobei eine der Schichten Al₂O₃ und ZrCN mindestens 1 µm dick ist.

5. Verbundkörper nach einem der Ansprüche 1 bis 4, dadurch gekennzeichnet, daß der Substratkörper (12) aus Hartmetall, einem Stahl, einem Cermet oder einer Keramik, insbesondere auf der Basis von Si₃N₄ besteht, wobei vorzugsweise das Hartmetall aus WC mit 5,5 bis 8,5 Massen-% Co, vorzugsweise 5,5 bis 6,5 Massen-% Co als Binder oder aus 1 bis 3 Massen-% TiC, 2 bis 5 Massen-% TaC, 1 bis 3 Massen-% NbC, 5,5 bis 8,5 Massen-% Co, Rest WC besteht.

6. Verfahren zur Herstellung einer Beschichtung aus einem Carbonitrid des Zr, Hf, V, Nb, Ta oder Cr durch plasmaaktiviertes CVD auf einem Grundkörper oder auf einem beschichteten Grundkörper aus einem Hartmetall, Cermet, Stahl oder einer Keramik, bei dem die reaktive Gasatmosphäre bei der eingestellten Reaktionstemperatur neben Wasserstoff, Argon, einem Chlorid der genannten Metalle auch ionisierte und/oder nicht ionisierte Kohlenstoff-Stickstoff-Donatoren mit Dreifachbindungen enthält, wobei der Abstand der Bindung zwischen dem Kohlenstoff und dem Stickstoff bei Raumtemperatur zwischen 0,114 und 0,118 nm liegt, dadurch gekennzeichnet, daß die ionisierten und die nicht ionisierten C-N-Donatoren durch Ionisierung und thermische Dissoziation von Gasen mit Cyanidgruppen mittels einer Plasmaaktivierung bei Temperaturen zwischen 400°C und 700°C und einem Druck von 100 bis 1000 Pa erzeugt werden, wobei vorzugsweise die Plasmaaktivierung an dem als Kathode geschalteten Substratkörper mit einer gepulsten Gleichspannung durchgeführt wird.

7. Verfahren zur Herstellung einer Beschichtung aus einem Carbonitrid des Zr, Hf, V, Nb, Ta oder Cr auf einem Grundkörper oder auf einem beschichteten Grundkörper aus einem Hartmetall, Cermet, Stahl oder einer Keramik, wobei die Hartstoffschichten mittels CVD aufgetragen werden, wobei die Gasphase bei einer Reaktionstemperatur zwischen 700°C und 1100°C neben H₂ und/oder Ar sowie Chloriden der obengenannten Metalle auch Kohlenstoff- und Stickstoff-Donatoren enthält, die eine C-N-Molekülgruppe aufweisen, gekennzeichnet durch Drücke der Gasphase zwischen 5 kPa und 100 kPa.

8. Verfahren nach Anspruch 7, dadurch gekennzeichnet, daß die C-N-Molekülgruppe eine Cyanidgruppe-CN mit einer Dreifachbindung zwischen dem Kohlenstoff und dem Stickstoff enthält, deren Abstand bei Raumtemperatur zwischen 0,114 und 0,118 nm beträgt, vorzugsweise unter Verwendung von Acetonitril.

9. Verfahren nach einem der Ansprüche 6 bis 8, dadurch gekennzeichnet, daß die CN-Molekülgruppe Molekülgruppen mit einer einfachen Bindung zwischen dem Kohlenstoff und dem Stickstoff enthält.

10. Verwendung des Verbundkörpers nach einem der Ansprüche 1 bis 5 als Schneideinsatz zum Zerspanen oder als abrasiv belastetes Verschleißteil oder als Schneideinsatz zum Zerspanen durch Drehen oder als Schneideinsatz zum Zerspanen durch Fräsen.

## Claims

1. Composite body comprised of a substrate body (12) with a multilayer coating (13 to 16) of carbides, nitrides and/or carbonitrides of Ti, Zr, Hf, V, Nb and/or Ta on the one hand and from Al₂O₃ or ZrO₂ on the other hand, characterized in that either one at least a 2 *µ*m thick Al₂O₃ or ZrO₂ layer, a layer (16) of a carbonitride of Zr, Hf, V, Nb, Ta or Cr is deposited, or on at least a 2 *µ*m thick Al₂O₃ or ZrO₂ layer a thin intermediate layer and thereon a layer (16) of a carbonitride of Zr, Hf, V, Nb, Ta or Cr, is deposited, whereby the intermediate layer is either comprised of ZrC or ZrN with a maximum thickness of 0,5 *µ*m or of TiN with a maximum thickness of 0,1 *µ*m.

2. Composite body according to claim 1 characterized in that the layer (16) of a carbonitride of Zr, Hf, v, Nb, Ta or Cr has a thickness of at least 2 *µ*m to a maximum of 6 *µ*m and/or the Al₂O₃ layer or ZrO₂ layer has a thickness of at least 3 *µ*m or more and/or that on the layer (16) of carbonitride of Zr, Hf, V, Nb, Ta or Cr, one or more outer layers are deposited, whereby the thickness or the total thickness of this one or more layers does not exceed 2 *µ*m, preferably 1 *µ*m.

3. Composite body according to one of the claims 1 or 2, characterized in that the total thickness of the two layers (15, 16) of Al₂O₃ and/or ZrO₂ on the one hand and a carbonitride of Zr, Hf, V, Nb, Ta or Cr on the other hand is at least 5 µm and preferably a maximum of 10 *µ*m and/or that under the both layers (15, 16) of Al₂O₃ and/or ZrO₂ on the one hand and a carbonitride of Hr, Hf, V, Nb, Ta or Cr on the other, one ore more layers (13 to 15) of carbides, nitrides, carbonitrides of the elements of group IVa or group Va of the periodic system are provided, preferably with carbides, nitrides and/or carbonitrides of titanium, zirconium and/or hafnium.

4. Composite body according to one of the claims 1 to 3, characterized by a layer sequence (13 to 16) of TiN, TiCN, Al₂O₃ and ZrCN applied from inside outwardly onto the substrate body, preferably by the following layer thicknesses: TiN: 0,5 to 2 *µ*m; TiCN: 9 to 13 *µ*m; Al₂O₃: 2 to 4,5 *µ*m and ZrCN: 2 to 4 *µ*m or by the following layer thicknesses: TiN: 0,5 to 2 *µ*m; TiCN 9 to 13 *µ*m; Al₂O₃ and ZrCN: 4 to 6 *µ*m whereby one of the layers Al₂O₃ and ZrCN is at least 1 *µ*m thick.

5. Composite body according to one of claims 1 to 4, characterized in that the substrate body (12) is comprised of hard metal, steel, a cermet or a ceramic, especially of a Si₃N₄ basis, whereby preferably the hard metal is comprised of WC with 5,5 to 8,5 mass % Co, preferably 5,5 to 6,5 mass % Co as a binder or 1 to 3 mass % TiC, 2 to 5 mass % TaC, 1 to 3 mass % NbC, 5,5 to 8,5 mass % Co, the balance WC.

6. Process for producing a coating of a carbonitride of Zr, Hf, V, Nb, Ta or Cr by plasma activated CVD on a base body or a coated base body of a hard metal, cermet, steel or a ceramic in which the reactive gas atmosphere at the set reaction temperature, apart from hydrogen, argon, a chloride of the said metal also contains ionized and/or nonionized carbon-nitrogen donors with triple bonding, whereby the bond spacing between the carbon and the nitrogen at room temperature is between 0,114 and 0,118, characterized in that the ionized and the nonionized C-N donors are produced by ionization and thermal dissociation of gases with cyanide groups by means of a plasma activation at temperatures between 400°C and 700°C and a pressure of 100 to 1000 Pa, whereby preferably the plasma activation is carried out with a pulsed direct current with the substrate body connected as cathode.

7. Method of producing a coating of a carbonitride of Zr, Hf, V, Nb, Ta or Cr on a base body or a coated base body of a hard metal, cermet, steel or a ceramic, whereby the hard coating is applied by means of CVD, whereby the gas phase, at a reaction temperature between 700°C and 1100°C, apart from H₂ and/or Ar and chlorides of the above-mentioned metals also contains carbon donors and nitrogen donors which have a C-N molecular group, characterized by a pressure of the gas phase between 5 kPa and 100 kPa.

8. Method according to claim 7, characterized in that the C-N molecule group contains a cyanide group-CN with a triple bond between the carbon and the nitrogen whose spacing at room temperature is between 0,114 and 0,118 nm, preferably with the use of acetonitrile.

9. Method according to one of the claims 6 to 8, characterized in that the CN molecular group contains molecular groups with a single bond between the carbon and the nitrogen.

10. Use of the composite body according to one of claims 1 to 5 as a cutting insert for chip removal and/or abrasively loaded wear parts or as a cutting insert for chip removal by turning or by milling.

## Revendications

1. Corps composite se composant d'un corps substrat (12) avec un revêtement à plusieurs couches (13 à 16) en carbures, nitrures et/ou carbonitrures du Ti, Zr, Hf, V, Nb et/ou du Ta d'un côté et en Al₂O₃ ou en ZrO₂ de l'autre côté,
**caractérisé par le fait que**
ou sur une couche en Al₂O₃ ou en ZrO₂ ayant une épaisseur de 2 µm du moins a été déposée une couche (16) en un carbonitrure du Zr, Hf, V, Nb, Ta ou du Cr, ou sur une couche en Al₂O₃ ou en ZrO₂ ayant une épaisseur de 2 µm du moins a été déposée une mince couche intermédiaire et sur celle-ci une couche (16) en un carbonitrure du Zr, Hf, V, Nb, Ta ou du Cr, la couche intermédiaire se composant soit de ZrC ou de ZrN avec une épaisseur maximale de 0,5 µm, soit de TiN avec une épaisseur maximale de 0,1 µm.

2. Corps composite selon la revendication 1, caractérisé par le fait que la couche (16) en un carbonitrure du Zr, Hf, V, Nb, Ta ou du Cr présente une épaisseur comprise entre 2 µm du moins et 6 µm au maximum, et/ou que la couche en Al₂O₃ ou en ZrO₂ présente une épaisseur d'au moins 3 µm ou plus, et/ou qu'une ou plusieurs couche(s) extérieure(s) ont été appliquée(s) sur la couche (16) en un carbonitrure du Zr, Hf, V, Nb, Ta ou du Cr, l'épaisseur ou l'épaisseur totale de cette couche ou de ces plusieurs couches n'excédant pas 2 µm, de préférence 1 µm.

3. Corps composite selon l'une des revendications 1 ou 2, caractérisé par le fait que l'épaisseur totale des deux couches (15, 16) en Al₂O₃ et/ou en ZrO₂ d'un côté et en un carbonitrure du Zr, Hf, V, Nb, Ta ou du Cr de l'autre côté est de 5
µm du moins et de préférence de 10 µm au maximum, et/ou qu'une ou plusieurs couches (13 à 15) en carbures, nitrures, carbonitrures des éléments du groupe IVa ou du groupe Va de la classification périodique des éléments, de préférence en carbures, nitrures et/ou carbonitrures du titane, du zirconium et/ou du hafnium, sont disposées au-dessous des deux couches (15, 16) en Al₂O₃ et/ou en ZrO₂ d'un côté et en un carbonitrure du Zr, Hf, V, Nb, Ta ou du Cr de l'autre côté.

4. Corps composite selon l'une des revendications 1 à 3, caractérisé par une suite de couches (13 à 16) en TiN, TiCN, Al₂O₃ et ZrCN, appliquée de l'intérieur vers l'extérieur sur le corps substrat (12), de préférence par les épaisseurs suivantes des couches: TiN: 0,5 à 2 µm; TiCN: 9 à 13 µm; Al₂O₃: 2 à 4,5 µm et ZrCN: 2 à 4 µm ou par les épaisseurs suivantes des couches: TiN: 0,5 à 2 µm; TiCN: 9 à 13 µm; Al₂O₃ et ZrCN: 4 à 6 µm, une des couches en Al₂O₃ et en ZrCN présentant une épaisseur de 1 µm du moins.

5. Corps composite selon l'une des revendications 1 à 4, caractérisé par le fait que le corps substrat (12) se compose de métal dur, d'un acier, d'un cermet ou d'une céramique, en particulier à partir de Si₃N₄, le métal dur se composant de préférence de WC avec 5,5 à 8,5 % en masse de Co, de préférence de 5,5 à 6,5 % en masse de Co comme liant ou de 1 à 3 % en masse de TiC, de 2 à 5 % en masse de TaC, de 1 à 3 % en masse de NbC, de 5,5 à 8,5 % en masse de Co, le reste WC.

6. Procédé de fabrication d'un revêtement en un carbonitrure du Zr, Hf, V, Nb, Ta ou du Cr par un CVD activé par plasma sur un corps de base ou sur un corps revêtu de base en un métal dur, un cermet, un acier ou une céramique, dans le cas duquel l'atmosphère réactif de gaz à la température réglée de réaction contient outre l'hydrogène, l'argon, un chlorure des métaux mentionnés, aussi des donneurs ionisés et/ou non ionisés de carbone et d'azote avec des liaisons triples, la distance de la liaison entre le carbone et l'azote à la température ambiante étant comprise entre 0,114 et 0,118 nm, caractérisé par le fait que les donneurs C-N ionisés et les donneurs C-N non ionisés sont produits par ionisation et dissociation thermique de gaz avec des groupes de cyanure au moyen d'une activation par plasma à des températures comprises entre 400°C et 700°C et à une pression de 100 à 1000 Pa, de préférence l'activation par plasma sur le corps substrat connecté en tant que cathode étant effectuée avec une tension continue pulsée.

7. Procédé de fabrication d'un revêtement en un carbonitrure du Zr, Hf, V, Nb, Ta ou du Cr sur un corps de base ou sur un corps revêtu de base en un métal dur, un cermet, un acier ou une céramique, les couches en matière dure étant appliquées au moyen du CVD, la phase gazeuse, à une température de réaction comprise entre 700°C et 1100°C, contenant outre H₂ et/ou Ar et des chlorures des métaux susmentionnés aussi des donneurs de carbone et d'azote qui présentent un groupe moléculaire C-N, caractérisé par des pressions de la phase gazeuse comprises entre 5 kPa et 100 kPa.

8. Procédé selon la revendication 7, caractérisé par le fait que le groupe moléculaire C-N contient un groupe de cyanure CN avec une liaison triple entre le carbone et l'azote, dont la distance à la température ambiante est comprise entre 0,114 et 0,118 nm, de préférence avec l'utilisation d'acétonitrile.

9. Procédé selon l'une des revendications 6 à 8, caractérisé par le fait que le groupe moléculaire CN contient des groupes moléculaires avec une liaison simple entre le carbone et l'azote.

10. Utilisation du corps composite selon l'une des revendications 1 à 5 comme insert de coupe pour l'enlèvement de copeaux ou comme pièce d'usure soumise à des efforts abrasifs ou comme insert de coupe pour l'enlèvement de copeaux par tournage ou comme insert de coupe pour l'enlèvement de copeaux par fraisage.
